# EUROPÄISCHE PATENTANMELDUNG

(11) **EP 3 722 975 A1**
(43) Veröffentlichungstag der Anmeldung: **14.10.2020**
(21) Anmeldenummer: 19167881.2
(22) Anmeldetag: 08.04.2019
(51) Int. Cl.: G06F 17/50

(54) **VERFAHREN UND VORRICHTUNG ZUM GENERIEREN EINES COMPUTERGESTÜTZTEN SIMULATIONSMODELLS FÜR EIN TECHNISCHES SYSTEM**

(71) Anmelder: Siemens Aktiengesellschaft, 80333 München (DE)
(72) Erfinder: Baudisch, Thomas, 86938 Schondorf am Ammersee (DE); Botero Halblaub, Andrés, 85614 Kirchseeon (DE); Fischer, Jan, 81541 München (DE); Garhammer, Andreas, 84367 Reut (DE); Liu, Siyuan, 81369 München (DE); Smirnov, Denis, 81543 München (DE); Wehrstedt, Jan Christoph, 81829 München (DE); Zhou, Yayun, 81739 München (DE)

(57) **Zusammenfassung**

Die Erfindung betrifft ein computerimplementiertes Verfahren und eine Vorrichtung zum Generieren eines computergestützten Simulationsmodells (SM) für ein technisches System, beispielsweise eine Fabrikanlage. Es werden Modelldaten (MD) des technischen Systems und eine Vielzahl von Simulationskomponenten (SK), wobei einer jeweiligen Simulationskomponente jeweils erste Kennungsdaten (KND1) zugeordnet sind, bereitgestellt. Mittels beispielsweise einer Bag-of-Words-Methode werden aus den bereitgestellten Modelldaten (MD) zweite Kennungsdaten (KND2) von Komponenten des technischen Systems extrahiert. Mittels einer maschinellen Lernmethode (NN1) die trainiert ist, anhand von extrahierten zweiten Kennungsdaten (KND2) aus Modelldaten eines technischen Systems eine Simulationskomponente (SK) aus einer Vielzahl von Simulationskomponenten derart zu selektieren und einer Komponente zuzuordnen, dass eine Differenz zwischen den zweiten Kennungsdaten und den ersten Kennungsdaten der Simulationskomponente minimiert wird, werden entsprechende Simulationskomponenten (SK) selektiert und ausgegeben. Aus den selektierten Simulationskomponenten (SK) wird in Abhängigkeit von den Modelldaten ein computergestütztes Simulationsmodell (SM) generiert.

## Beschreibung

Die Erfindung betrifft ein computerimplementiertes Verfahren und eine Vorrichtung zum Generieren eines computergestützten Simulationsmodells für ein technisches System mittels einer maschinellen Lernmethode. Ferner ist die Erfindung auf ein Computerprogrammprodukt zum Ausführen der Schritte eines erfindungsgemäßen Verfahrens gerichtet.

Computergestützte Simulationen können als digitales Planungsinstrument von technischen Systemen, z.B. Fabrikanlagen, genutzt werden. Mittels Simulationen können beispielsweise Planungsentwürfe validiert werden. Des Weiteren können Simulationen während der Betriebsphase einer Anlage eingesetzt werden, um beispielsweise betriebsgleitende Assistenzsysteme zu realisieren. Für beide Arten von Simulationen sind Simulationswerkzeuge oder Simulationstools bekannt, mit denen Simulationsmodelle aus bestehenden Simulationskomponenten-Bibliotheken manuell von einem Simulationsexperten erstellt werden können. Die Erstellung eines Simulationsmodells auf Basis eines verfügbaren Fabrikplans und verfügbarer Fabrikdaten erfordert in der Regel ein hohes Maß an Fachwissen vom Simulationsexperten, da dieser zunächst geeignete Simulationskomponenten zum Abbilden der realen Fabrikkomponenten bestimmen und/oder erstellen muss. Daher kann die Erstellung eines Simulationsmodells zeitaufwändig, fehleranfällig und/oder qualitativ unterschiedlich sein.

Es ist daher eine Aufgabe der vorliegenden Erfindung, die Erstellung eines Simulationsmodells für ein technisches System, wie z.B. eine Fabrikanlage, zu erleichtern.

Die Aufgabe wird durch die in den unabhängigen Ansprüchen beschriebenen Maßnahmen gelöst. In den abhängigen Ansprüchen sind vorteilhafte Weiterbildungen der Erfindung dargestellt.

Gemäß einem ersten Aspekt betrifft die Erfindung ein computerimplementiertes Verfahren zum Generieren eines computergestützten Simulationsmodells für ein technisches System, umfassend die Verfahrensschritte:
- Einlesen von Modelldaten des technischen Systems,
- Bereitstellen einer Vielzahl von Simulationskomponenten zum computergestützten Simulieren des technischen Systems, wobei einer jeweiligen Simulationskomponente jeweils erste Kennungsdaten zugeordnet sind,
- Extrahieren von zweiten Kennungsdaten von Komponenten des technischen Systems aus den bereitgestellten Modelldaten,
- Bereitstellen einer ersten maschinellen Lernmethode, die trainiert ist, anhand von extrahierten zweiten Kennungsdaten aus Modelldaten eines technischen Systems eine Simulationskomponente aus einer Vielzahl von Simulationskomponenten derart zu selektieren und einer Komponente zuzuordnen, dass eine Differenz zwischen den zweiten Kennungsdaten und den ersten Kennungsdaten der Simulationskomponente minimiert wird,
- Selektieren von entsprechenden Simulationskomponenten aus der bereitgestellten Vielzahl von Simulationskomponenten in Abhängigkeit der bereitgestellten Modelldaten und mittels der ersten maschinellen Lernmethode,
- Ausgeben der zugeordneten Simulationskomponenten an eine Simulationseinheit
   und
- Generieren des computergestützten Simulationsmodells aus den selektierten Simulationskomponenten in Abhängigkeit von den Modelldaten in der Simulationseinheit.

Sofern es in der nachfolgenden Beschreibung nicht anders angegeben ist, beziehen sich die Begriffe "durchführen", "berechnen", "bereitstellen", "rechnergestützt", "rechnen", "feststellen", "generieren", "konfigurieren", "rekonstruieren", "extrahieren" und dergleichen, vorzugsweise auf Handlungen und/oder Prozesse und/oder Verarbeitungsschritte, die Daten verändern und/oder erzeugen und/oder die Daten in andere Daten überführen, wobei die Daten insbesondere als physikalische Größen dargestellt werden oder vorliegen können, beispielsweise als elektrische Impulse. Insbesondere sollte der Ausdruck "Computer" möglichst breit ausgelegt werden, um insbesondere alle elektronischen Geräte mit Datenverarbeitungseigenschaften abzudecken. Computer können somit beispielsweise Personal Computer, Server, Handheld-Computer-Systeme, Pocket-PC-Geräte, Mobilfunkgeräte und andere Kommunikationsgeräte, die rechnergestützt Daten verarbeiten können, Prozessoren und andere elektronische Geräte zur Datenverarbeitung sein.

Unter "computergestützt" kann im Zusammenhang mit der Erfindung beispielsweise eine Implementierung des Verfahrens verstanden werden, bei dem insbesondere ein Prozessor mindestens einen Verfahrensschritt des Verfahrens ausführt.

Die Erfindung ermöglicht die Erstellung eines Simulationsmodells, um damit computergestützt ein reales technisches System zu simulieren. Die computergestützte Simulation bzw. Computersimulation dient beispielsweise dazu, physikalische Prozesse abzubilden und zu analysieren. Es ist ein wichtiger Vorteil der vorliegenden Erfindung mittels einer maschinellen Lernmethode, z.B. einem neuronalen Netz, automatisch den entsprechenden realen Komponenten eines realen technischen Systems Simulationskomponenten, beispielsweise aus einer Simulationskomponentenbibliothek, zuzuordnen. Eine Zuordnung kann insbesondere derart gestaltet sein, dass einer realen Komponente mehr als eine Simulationskomponente, oder einer Kombination aus mehreren Simulationskomponenten, bzw. verschiedenen realen Komponenten jeweils die gleiche Simulationskomponente zugeordnet werden kann.

Ein technisches System kann beispielsweise eine Anlage oder eine Fabrikanlage oder eine Maschine, wie z.B. ein Generator oder ein Motor, oder eine Werkzeugmaschine, etc., sein. Komponenten des technischen Systems sind insbesondere Teile des Systems, wie z.B. einzelne Maschinen. Komponenten des realen technischen Systems können Hardware- und/oder Software-Komponenten sein. Simulationskomponenten sind entsprechend Abbildungen der realen Komponenten, die vorzugsweise derart gestaltet sind, dass damit physikalische und/oder funktionale Prozesse und/oder Eigenschaften der realen Komponente computergestützt simuliert werden können. Die Zuordnung der realen Komponenten zu den Simulationskomponenten mittels der ersten maschinellen Lernmethode basiert insbesondere auf vorgegebenen Modelldaten des technischen Systems. Modelldaten können beispielsweise in Form eines formalisierten Engineering-Modells oder als formalisierte Beschreibungsdaten vorliegen. Modelldaten umfassen insbesondere Informationen über das technische System, wie z.B. Fabrikpläne, Fabrikdaten, Produktdaten, und/oder Produktionspläne.

Anhand der Modelldaten werden Informationen zu vorhandenen Komponenten des technischen Systems ermittelt. Dazu kann beispielsweise eine Bag-of-Words-Methode genutzt werden. Damit können beispielsweise aus einem formalisierten Modell des technischen Systems Textteile extrahiert und bereitgestellt werden. Insbesondere können die extrahierten Textteile zweite Kennungsdaten von Komponenten, wie z.B. Bezeichnungen der Komponenten, umfassen.

Simulationskomponenten können insbesondere anhand von ersten Kennungsdaten, die jeweils Simulationskomponenten kennzeichnen, den entsprechenden realen Komponenten zugeordnet werden. Eine Simulationskomponente bildet vorzugsweise die Physik und/oder technische Ausführung einer realen Komponente ab.

Kennungsdaten, d.h. sowohl erste als auch zweite Kennungsdaten, können beispielsweise eine Bezeichnung, Kennzeichnung, ein Name, ein Label, eine Beschreibung, Kurzbeschreibung oder ähnliches sein. Kennungsdaten sind jeweils vorzugsweise eindeutig einer Komponente bzw. einer Simulationskomponente zugeordnet. Anhand von Kennungsdaten können die jeweiligen Komponenten bzw. Simulationskomponenten beschrieben und/oder identifiziert werden.

Die Erstellung eines computergestützten Simulationsmodells aus den selektierten Simulationskomponenten kann vorzugsweise mittels eines Simulationswerkzeugs - auch als Simulationstool bezeichnet - in einer Simulationseinheit, die mindestens einen Prozessor umfasst, durchgeführt werden. Die Erstellung des Simulationsmodells wird auf Basis der Modelldaten des technischen Systems in Abhängigkeit der Topologie durchgeführt.

Weitere Vorteile der vorliegenden Erfindung liegen in einer Reduktion des manuellen Aufwandes bei der Erstellung eines Simulationsmodells, da die Simulationsmodellgenerierung und/oder -parametrisierung automatisch durchgeführt werden kann. Dies ermöglicht auch eine gleichbleibende Qualität der Simulationsmodelle. Ferner ermöglich der Ansatz eine bessere Synchronisierung eines Simulationsmodells mit einer bestehenden Fertigung. Der vorgeschlagene datenbasierte Ansatz über neuronale Netze ist insbesondere robuster und flexibler, als z.B. ein regelbasierter Ansatz, bei dem Modelle automatisch aus vorher festgelegten Regeln erzeugt werden.

In einer vorteilhaften Ausführungsform des computerimplementierten Verfahrens kann das computergestützte Simulationsmodell mittels einer zweiten maschinellen Lernmethode parametrisiert werden, wobei
- aus Modelldaten eines technischen Systems Parameter für eine Komponente des technischen Systems ermittelt werden,
- und die zweite maschinelle Lernmethode derart trainiert ist, ermittelte Parameter einer Simulationskomponente, die mittels der ersten maschinellen Lernmethode einer jeweiligen Komponente zugeordnet ist, zuzuordnen.

Bei der Parametrisierung wird das Simulationsmodell mit konkreten Rechenwerten ausgestattet, dass das Modell möglichst gut den konkreten Anwendungsfall abbildet. Vorzugsweise wird die zweite maschinelle Lernmethode nach der ersten maschinellen Lernmethode ausgeführt, so dass eine hierarchische Zuordnung realisiert wird. Das erstellte computergestützte Simulationsmodell bzw. die selektierten und zugeordneten Simulationskomponenten können auf Basis der Informationen aus den Modelldaten des technischen Systems, das vorzugsweise Angaben zu Parametern bzw. Parameterwerten umfasst, an das reale technische System angepasst werden. Die Parametrisierung erfolgt vorzugsweise mittels einer zweiten Bag-of-Words-Methode und eines zweiten neuronalen Netzes. Parameter einer Komponente können beispielsweise direkt Parametern einer entsprechenden Simulationskomponente zugeordnet werden. Parameter können beispielsweise physikalische und/oder funktionale Parameter sein.

In einer vorteilhaften Ausführungsform des computerimplementierten Verfahrens kann die erste maschinelle Lernmethode und/oder die zweite maschinelle Lernmethode eine Methode zur Verarbeitung von Textdaten und/oder ein künstliches neuronales Netz und/oder ein Bayes-Klassifikator umfassen.

Vorzugsweise kann die Zuordnung der Simulationskomponenten zu den entsprechenden realen Komponenten und die anschließende Parametrisierung auf Basis von Textdaten und/oder computerlesbaren Textdaten erfolgen.

In einer vorteilhaften Ausführungsform des computerimplementierten Verfahrens kann das technische System und/oder ein Prozess oder eine Funktionalität des technischen Systems mittels des computergestützten Simulationsmodells computergestützt simuliert werden und die Simulationsdaten des computergestützten Simulationsmodells können zum Steuern oder Planen des technischen Systems ausgegeben werden.

Nach der Generierung und Parametrisierung des computergestützten Simulationsmodells kann dieses bereitgestellt und in einer Simulationsumgebung ausgeführt werden. Insbesondere können anschließend die entsprechenden Simulationsdaten zum Steuern des realen technischen Systems ausgegeben werden. Beispielsweise kann das Simulationsmodell auch zum computergestützten Planen des technischen Systems ausgegeben werden.

In einer vorteilhaften Ausführungsform des computerimplementierten Verfahrens kann das technische System und/oder ein Prozess und/oder eine Funktionalität und/oder eine Spezifikation des technischen Systems mittels der computergestützten Simulation und anhand einer vorgegebenen Regel validiert werden.

Eine Validierung kann beispielsweise auf Basis der vorgegebenen Modelldaten und der bei der Ausführung der Simulation erzeugten Simulationsdaten erfolgen.

In einer vorteilhaften Ausführungsform des computerimplementierten Verfahrens kann die erste maschinelle Lernmethode mittels Trainingsdaten trainiert worden sein, anhand von extrahierten zweiten Kennungsdaten aus Modelldaten eines technischen Systems eine Simulationskomponente aus einer Vielzahl von Simulationskomponenten derart zu selektieren und einer Komponente zuzuordnen, dass eine Differenz zwischen den zweiten Kennungsdaten und den ersten Kennungsdaten der Simulationskomponente minimiert wird, wobei die Trainingsdaten eine Vielzahl von Modelldaten von technischen Systemen und erste Kennungsdaten von einer Vielzahl von Simulationskomponenten umfassen.

Die Trainingsdaten umfassen vorzugsweise Informationen über eine Vielzahl von technischen Systemen, die dem zu simulierenden technischen System ähnlich sind, d.h. Systeme die beispielsweise vergleichbare Zielvorgaben und/oder gleichartige Komponenten aufweisen.

In einer vorteilhaften Ausführungsform des computerimplementierten Verfahrens kann die zweite maschinelle Lernmethode mittels der Trainingsdaten derart trainiert worden sein, ermittelte Parameter einer Simulationskomponente, die mittels der ersten maschinellen Lernmethode einer jeweiligen Komponente zugeordnet wurde, zuzuordnen.

In einer vorteilhaften Ausführungsform des computerimplementierten Verfahrens können Modelldaten für ein technisches System Textdaten umfassen, die Produkttypen und/oder der Produktion dieser Produkttypen zugehörige Prozessschritte und/oder eine Reihenfolge von Prozessschritten und/oder vorhandene Komponenten und/oder Positionen vorhandener Komponenten des technischen Systems kennzeichnen.

Modelldaten können insbesondere das technische System beschreiben bzw. abbilden und/oder Information über das technische System umfassen. Modelldaten sind vorzugsweise systemspezifisch, d.h. sind einem individuellen technischen System zugeordnet.

Gemäß einem zweiten Aspekt betrifft die Erfindung eine Vorrichtung zum Generieren eines computergestützten Simulationsmodells für ein technisches System, wobei die Vorrichtung mindestens einen Prozessor zum Durchführen der Schritte eines Verfahrens nach den vorhergehenden Ansprüchen aufweist.

Bei einem Prozessor kann es sich insbesondere um einen Hauptprozessor (engl. Central Processing Unit, CPU), einen Mikroprozessor oder einen Mikrokontroller, beispielsweise eine anwendungsspezifische integrierte Schaltung oder einen digitalen Signalprozessor, möglicherweise in Kombination mit einer Speichereinheit zum Speichern von Programmbefehlen, etc. handeln. Bei einem Prozessor kann es sich beispielsweise auch um einen IC (integrierter Schaltkreis, engl. Integrated Circuit) oder einen Grafikprozessor GPU (Graphics Processing Unit) handeln. Der Prozessor kann eine oder mehrere Rechenkerne (multi-core) aufweisen. Auch kann unter einem Prozessor ein virtualisierter Prozessor oder eine Soft-CPU verstanden werden. Es kann sich beispielsweise auch um einen programmierbaren Prozessor handeln, der mit Konfigurationsschritten zur Ausführung des genannten erfindungsgemäßen Verfahrens ausgerüstet wird oder mit Konfigurationsschritten derart konfiguriert ist, dass der programmierbare Prozessor die erfindungsgemäßen Merkmale des Verfahrens oder anderer Aspekte und Teilaspekte der Erfindung implementiert.

Des Weiteren betrifft die Erfindung ein Computerprogrammprodukt, das direkt in einen programmierbaren Computer ladbar ist, umfassend Programmcodeteile, die dazu geeignet sind, die Schritte eines erfindungsgemäßen computerimplementierten Verfahrens durchzuführen.

Ein Computerprogrammprodukt, wie zum Beispiel ein Computerprogramm-Mittel, kann beispielsweise als Speichermedium oder Datenträger, wie zum Beispiel als Speicherkarte, USB-Stick, CD-ROM, DVD oder auch in Form einer herunterladbaren Datei von einem Server in einem Netzwerk bereitgestellt oder geliefert werden.

Ausführungsbeispiele des erfindungsgemäßen computerimplementierten Verfahrens und der Vorrichtung sind in den Zeichnungen beispielhaft dargestellt und werden anhand der nachfolgenden Beschreibung näher erläutert. Es zeigen:
- Fig. 1:: ein Ablaufdiagramm eines Ausführungsbeispiels eines erfindungsgemäßen Verfahrens;
- Fig. 2:: eine schematische Darstellung eines weiteren Ausführungsbeispiels eines erfindungsgemäßen Verfahrens; und
- Fig. 3:: eine schematische Darstellung einer erfindungsgemäßen Vorrichtung in Blockdarstellung.

Einander entsprechende Teile sind in allen Figuren mit den gleichen Bezugszeichen versehen.

Insbesondere zeigen die nachfolgenden Ausführungsbeispiele lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis des/der Verfahrensanspruchs/Verfahrensansprüche alle im Stand der Technik üblichen Möglichkeiten zur Realisierung der Erfindung selbstverständlich bekannt, sodass es insbesondere einer eigenständigen Offenbarung in der Beschreibung nicht bedarf.

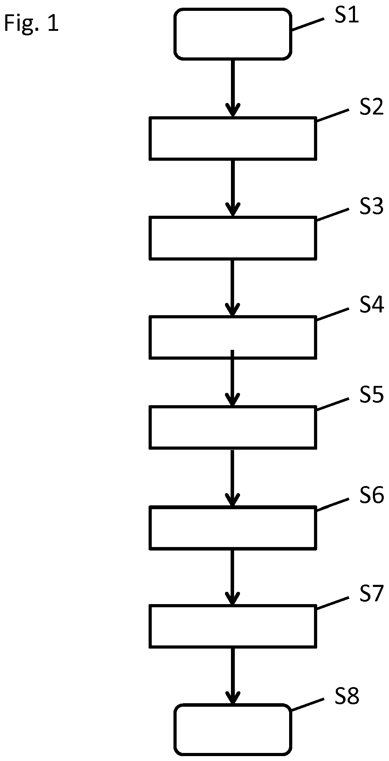

Figur 1 zeigt ein Ablaufdiagramm eines erfindungsgemäßen computerimplementierten Verfahrens zur Generierung eines computergestützten Simulationsmodells für ein technisches System, wie z.B. eine Fabrikanlage. Das computergestützte Simulationsmodell kann weiter dazu genutzt werden, Prozesse der Fabrikanlage zu computergestützt zu simulieren und/oder zu validieren.

Vorzugsweise liegen für die Fabrikanlage ein Fabrikplan und/oder Fabrikdaten in Form einer formalisierten Beschreibung bzw. einem formalisierten Engineering-Modell vor. Diese Modelldaten der Fabrikanlage werden im ersten Schritt S1 bereitgestellt und zur weiteren Verarbeitung eingelesen. Beispielsweise liegen die Modelldaten als computerlesbare Textdaten, z.B. in einer XML-Datei gespeichert, vor. Modelldaten umfassen vorzugsweise Textdaten, die Produkttypen und/oder der Produktion dieser Produkttypen zugehörige Prozessschritte und/oder eine Reihenfolge von Prozessschritten und/oder vorhandene Komponenten und/oder Positionen vorhandener Komponenten des technischen Systems kennzeichnen. Beispielsweise umfasst solch ein Engineering-Modell einer Fabrikanlage Maschinenbezeichnungen, eine Spezifikation der Anlage, Informationen zu Prozesstypen, Informationen zu Parametertypen und/oder Merkmale bzw. Eigenschaften von Komponenten der Fabrikanlage.

Im nächsten Schritt S2 werden Simulationskomponenten bereitgestellt, die insbesondere für die computergestützte Simulation des technischen Systems geeignet sind. Simulationskomponenten können beispielsweise als Programmcode bereitgestellt werden. Beispielsweise wird eine Bibliothek mit Simulationskomponenten, denen jeweils erste Kennungsdaten zugeordnet sind, abgerufen. Somit können beispielsweise Daten, die die Simulationskomponenten beschreiben, von der Bibliothek abgerufen und eingelesen werden. Simulationskomponenten sind insbesondere derart eingerichtet, jeweils die Physik und/oder Funktionen und/oder Prozesse einer entsprechenden realen Komponente abzubilden. Einer Simulationskomponente sind jeweils erste Kennungsdaten zugeordnet. Die ersten Kennungsdaten umfassen vorzugsweise eine eindeutige Identifikationskennung, wie z.B. eine Bezeichnung der Simulationskomponente, anhand derer die Simulationskennung einer realen Komponente zugeordnet werden kann.

Mittels einer Methode zur Verarbeitung von Textdaten, d.h. einer Methode zur Verarbeitung von natürlicher Sprache wie beispielsweise der Bag-of-Words-Methode, werden im nächsten Schritt S3 Textteile bzw. Informationsbruchteile aus den Modelldaten gewonnen. Die Bag-of-Words-Methode ermöglicht beispielsweise aus einer Fabrikbeschreibung zweite Kennungsdaten der Komponenten zu extrahieren und in eine binäre Matrix umzuwandeln. Beispielsweise können Modelldaten Textdaten wie "Mixer", "mixen", "Station", "Tank" und weitere Merkmale umfassen, d.h. beispielsweise Namen oder Bezeichnungen von Komponenten der Fabrikanlage. Mittels der Bag-of-Words-Methode werden diese Textdaten extrahiert und als Eingabedaten für ein erstes künstliches neuronales Netz bereitgestellt. Das erste neuronale Netz wird vorzugsweise trainiert bereitgestellt, Schritt S4. Das neuronale Netz kann beispielsweise als Datenstruktur gespeichert bereitgestellt werden, z.B. in einer Speichereinheit gespeichert, und von dort aus zur weiteren Verarbeitung eingelesen werden.

Das erste neuronale Netz ist vorzugsweise darauf trainiert, anhand von extrahierten zweiten Kennungsdaten, die mindestens eine Komponente des technischen Systems kennzeichnen, aus Modelldaten des technischen Systems eine Simulationskomponente aus einer Vielzahl von Simulationskomponenten derart zu selektieren und der realen Komponente zuzuordnen, dass eine Differenz zwischen den zweiten Kennungsdaten und den ersten Kennungsdaten der Simulationskomponente minimiert wird. In anderen Worten, das erste neuronale Netz ermöglicht eine automatische Zuordnung von Simulationskomponenten auf die Komponenten einer Fabrikanlage, die anhand der Modelldaten der Fabrikanlage bestimmt wurden. Die Zuordnung kann beispielsweise anhand der Bezeichnungen der Komponenten bzw. der Simulationskomponenten durchgeführt werden, d.h. die Ausgabe des ersten neuronalen Netzes können insbesondere zugeordnete erste Kennungsdaten sein.

Das erste neuronale Netz ist insbesondere darauf trainiert, zu einer bestimmten Komponente anhand deren zweiten Kennungsdaten eine passende Simulationskomponente zu bestimmen, wobei eine Differenz zwischen den zweiten Kennungsdaten und den ersten Kennungsdaten der Simulationskomponente minimiert wird. Die Kennungsdaten können jeweils insbesondere Namen, Bezeichnungen oder Identifikationskennungen sein.

Das neuronale Netz wird insbesondere vorab trainiert. Zum Training des ersten neuronalen Netzes werden vorzugsweise Trainingsdaten bereitgestellt, die eine Vielzahl von Modelldaten von technischen Systemen und erste Kennungsdaten von einer Vielzahl von Simulationskomponenten umfassen. Beim Training des neuronalen Netzes werden die Gewichtungen der künstlichen Neuronen angepasst, um eine Ausgabe, wie z.B. die korrekte Zuordnung einer Simulationskomponente auf Basis von zweiten Kennungsdaten, zu optimieren.

Um sich Trainingsdaten zu generieren können mithilfe einer Suchmaschine oder eines Webcrawlers, Informationen für Produkttypen, den zugehörigen Prozessschritten und mögliche Maschinen mit den zugehörigen Daten aus Herstellerwebseiten aus dem Internet automatisiert extrahiert werden. Danach können mithilfe eines Optimierers und Randbedingungen, z.B. Kapazität oder Energieverbrauch der Fabrik, validierte Engineering-Modelle einer Fabrik aus den gesammelten Daten erzeugt werden. Aus diesen Trainingsdaten können dann Simulationsmodelle manuell für das Training einer maschinellen Lernmethode erstellt werden.

Im nächsten Schritt S5 wird das trainierte erste neuronale Netz ausgeführt, wobei die Eingabedaten von der Bag-of-Words-Methode in das erste neuronale Netz eingegeben werden. Die Ausgabe des ersten neuronalen Netzes ist die Simulationskomponente mit den ersten Kennungsdaten, die mit höchster Wahrscheinlichkeit der realen Komponente der Fabrikanlage entspricht. Beispielsweise kann zu zweiten Kennungsdaten "mixen" eine Simulationskomponente mit zweiten Kennungsdaten "Mixer" zugeordnet werden, so dass die Differenz bzw. Abweichung zwischen den ersten und zweiten Kennungsdaten minimiert wird. Eine Differenz kann beispielsweise durch einen Vergleich der ersten und zweiten Kennungsdaten berechnet werden. Alternativ zu einem neuronalen Netz kann für die Zuordnung auch Naive Bayes-Klassifikator verwendet werden.

Die derart selektierten Simulationskomponenten werden im nächsten Schritt S6 an eine Simulationseinheit, das z.B. ein computergestütztes Simulationstool umfasst, ausgegeben. Es können auch lediglich die ersten Kennungsdaten der zugeordneten Simulationskomponenten ausgegeben werden. Vorzugsweise wird die Ausgabe in einem Format bereitgestellt, das von einem Computer gelesen und verarbeitet werden kann. Vom Simulationstool wird anschließend, Schritt S7, aus den selektierten Simulationskomponenten ein computergestütztes Simulationsmodell generiert und beispielsweise bereitgestellt. Das Simulationstool weist vorzugsweise eine Programmierschnittstelle auf, über die die ausgegebenen Simulationskomponenten eingelesen werden können. Ein Simulationstool ist vorzugsweise derart eingerichtet, dass aus der eingegebenen Menge von Simulationskomponenten in Abhängigkeit der Modelldaten des technischen Systems ein ausführbares Simulationsmodell erstellt werden kann.

Das Simulationsmodell kann anschließend beispielsweise zum Steuern oder Planen des technischen Systems ausgegeben werden. Beispielsweise kann das technische System anhand des Simulationsmodells computergestützt geplant werden.

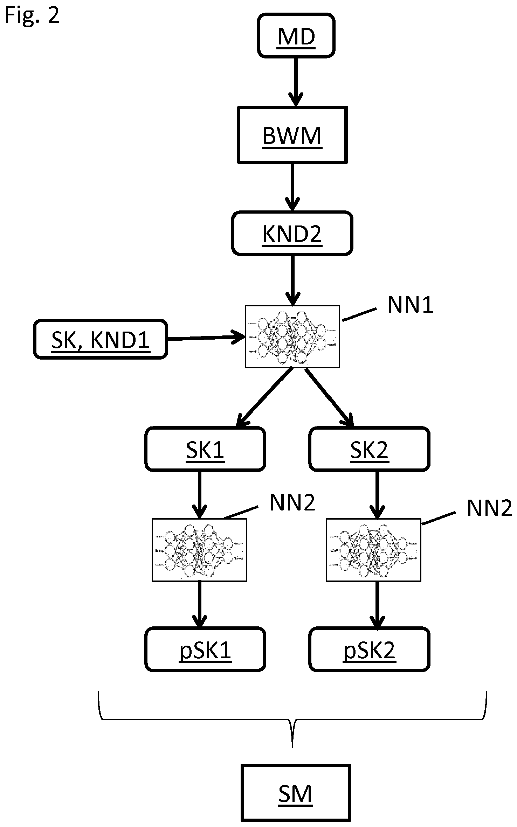

Figur 2 zeigt schematisch ein erfindungsgemäßes Verfahren zum Generieren eines computergestützten Simulationsmodells für ein technisches System, wie z.B. eine Fabrikanlage.

Der Ausgangspunkt des Verfahrens sind Modelldaten MD der Fabrikanlage, die vorzugsweise in computerlesbarer Textform vorliegen. Die Modelldaten MD werden beispielsweise mittels einer Bag-of-Words-Methode BWM analysiert, wobei zweite Kennungsdaten KND2, die jeweils Komponenten der Fabrikanlage kennzeichnen, aus den Modelldaten extrahiert werden.

Die extrahierten zweiten Kennungsdaten KND2 werden einem trainierten ersten neuronalen Netz NN1 übergeben. Das erste neuronale Netz NN1 ist vorzugsweise darauf trainiert, aus einer Menge von Simulationskomponenten SK, denen jeweils erste Kennungsdaten KND1 zugeordnet sind, diejenigen Simulationskomponenten SK1, SK2 zu ermitteln, die den realen Komponenten der Fabrikanlage entsprechen, wobei eine Differenz zwischen den ersten Kennungsdaten KND1 und den eingegebenen zweiten Kennungsdaten KND2 minimiert wird.

Die Ausgabe des ersten neuronalen Netzes NN1 sind erste Kennungsdaten KND1, die den Simulationskomponenten SK1, SK2 zugeordnet sind, wobei hier lediglich beispielhaft zwei Simulationskomponenten gezeigt sind. Aus diesen Simulationskomponenten SK1, SK2 kann ein computergestütztes Simulationsmodell generiert werden. Um die Simulationskomponenten gemäß den Modelldaten MD der realen Fabrikanlage zu parametrisieren, kann jeweils ein zweites neuronales Netz NN2 genutzt werden. Alternativ kann das Simulationsmodell bereits vollständig parametrisiert und ausführbar generiert worden sein, so dass keine nachgelagerte Parametrisierung notwendig ist.

Das jeweilige zweite neuronale Netz NN2 ist vorzugsweise mittels Trainingsdaten darauf trainiert, aus Modelldaten eines technischen Systems ermittelte Parameter oder auch Parameterwerte einer Simulationskomponente SK, die mittels der ersten maschinellen Lernmethode NN1 einer jeweiligen Komponente zugeordnet ist, zuzuordnen. Trainingsdaten können insbesondere eine Vielzahl von Modelldaten von anderen Fabrikanlagen und erste Kennungsdaten von einer Vielzahl von Simulationskomponenten umfassen. In anderen Worten, es können beispielsweise mittels einer Bag-of-Words-Methode Parameter ermittelt werden, die als Eingabedaten für das zweite neuronale Netz NN2 dienen. Ausgehend von den ermittelten Parametern ist das zweite neuronale Netz NN2 darauf trainiert, beispielsweise den Namen des jeweiligen Inputparameters pSK1, pSK2 einer vorher klassifizierten Simulationskomponente K1, K2 zu liefern.

Die Zuordnung und Parametrisierung können auf verschiedenen Ebenen durchgeführt werden, wobei jede Ebene durch mindestens ein neuronales Netz realisiert wird. Auf diese Weise können die Simulationskomponenten SK der Simulationsbibliothek hierarchisch selektiert und anschließend klassifiziert werden, d.h. zuerst werden die Kategorien, dann die Komponenten der Kategorien und dann die zugehörigen Inputparameter der Kategorien zugeordnet. Die unteren Hierarchieebenen erben jeweils von den oberen.

Anschließend kann mittels eines Simulationstools aus den zugeordneten und parametrisierten Simulationskomponenten SK1, SK2 ein Simulationsmodell SM erstellt und ausgegeben werden. Beispielsweise kann der Aufbau und/oder ein Prozess der Fabrikanlage mittels des Simulationsmodells SM anhand einer vorgegebenen Regel validiert werden. Dazu kann eine physikalische oder prozesstechnische Simulation durchgeführt werden und resultierende Simulationsdaten können anhand der vorgegebenen Regel geprüft werden. Dies hat beispielsweise den Vorteil, dass eine Fabrikanlage vor einer Inbetriebnahme geprüft werden kann. Eine vorgegebene Regel kann beispielsweise eine Randbedingung, wie z.B. einen maximalen Energieverbrauch der Fabrikanlage, umfassen.

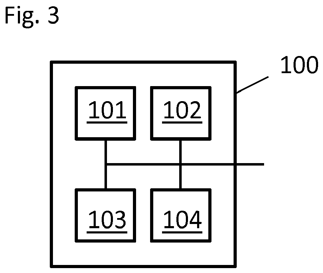

Figur 3 zeigt in schematischer Blockdarstellung eine erfindungsgemäße Vorrichtung 100 zum Generieren eines computergestützten Simulationsmodells für ein technisches System. Die Vorrichtung 100 umfasst mindestens einen Prozessor 101, der derart eingerichtet ist, die Schritte eines erfindungsgemäßen Verfahrens, wie beispielhaft anhand Figur 1 und/oder 2 gezeigt, durchzuführen. Des Weiteren umfasst die Vorrichtung vorzugsweise mindestens eine Speichereinheit 102 oder ist mit einer Speichereinheit oder Datenbank gekoppelt. Auf der Speichereinheit 102 können insbesondere eine Vielzahl von Simulationskomponenten als Simulationsbibliothek gespeichert und bereitgestellt werden. Außerdem kann die Speichereinheit 102 die trainierte erste und/oder zweite maschinelle Lernmethode speichern und als Datenstruktur bereitstellen. Beispielsweise können die jeweiligen maschinellen Lernmethoden in einer Trainingseinheit 103 mittels Trainingsdaten trainiert und an die Speichereinheit 102 bzw. an den Prozessor 101 übermittelt werden. Die Vorrichtung 100 kann außerdem eine Simulationseinheit 104 umfassen oder mit dieser gekoppelt sein, wobei die Simulationseinheit beispielsweise ein Simulationstool in Form von Software aufweist und derart eingerichtet ist, aus Simulationskomponenten ein auf einem Computer ausführbares Simulationsmodell zu erstellen und auszugeben. Des Weiteren kann die Simulationseinheit auch derart eingerichtet sein, das Simulationsmodell auszuführen. Die einzelnen Einheiten der Vorrichtung 100 können sowohl als Software und/oder als Hardware ausgestaltet sein und sind vorzugsweise vorteilhaft miteinander gekoppelt.

Das Simulationstool kann insbesondere ein Programmierschnittstelle (eng. Application Programming Interface, kurz API) aufweisen. Das Simulationsmodell kann durch die API des Simulationstools generiert werden. Durch die Schnittstelle kann auf das Simulationstool bzw. die internen Funktionen des Tools zugegriffen werden. Dadurch können die jeweiligen Simulationskomponenten im Tool erzeugt und entsprechend verbunden werden.

Alle beschriebenen und/oder gezeichneten Merkmale können im Rahmen der Erfindung vorteilhaft miteinander kombiniert werden. Die Erfindung ist nicht auf die beschriebenen Ausführungsbeispiele beschränkt.

## Patentansprüche

1. Computerimplementiertes Verfahren zum Generieren eines computergestützten Simulationsmodells für ein technisches System, umfassend die Verfahrensschritte:
- Einlesen (S1) von Modelldaten des technischen Systems,
- Bereitstellen (S2) einer Vielzahl von Simulationskomponenten (SK) zum computergestützten Simulieren des technischen Systems, wobei einer jeweiligen Simulationskomponente jeweils erste Kennungsdaten (KND1) zugeordnet sind,
- Extrahieren (S3) von zweiten Kennungsdaten (KND2) von Komponenten des technischen Systems aus den bereitgestellten Modelldaten (MD),
- Bereitstellen (S4) einer ersten maschinellen Lernmethode (NN1), die trainiert ist, anhand von extrahierten zweiten Kennungsdaten aus Modelldaten eines technischen Systems eine Simulationskomponente aus einer Vielzahl von Simulationskomponenten derart zu selektieren und einer Komponente zuzuordnen, dass eine Differenz zwischen den zweiten Kennungsdaten (KND2) und den ersten Kennungsdaten (KND1) der Simulationskomponente minimiert wird,
- Selektieren (S5) von entsprechenden Simulationskomponenten (SK1, SK2) aus der bereitgestellten Vielzahl von Simulationskomponenten (SK) in Abhängigkeit der bereitgestellten Modelldaten (MD) und mittels der ersten maschinellen Lernmethode (NN1),
- Ausgeben (S6) der zugeordneten Simulationskomponenten (SK1, SK2) an eine Simulationseinheit
und
- Generieren (S7) des computergestützten Simulationsmodells (SM) aus den selektierten Simulationskomponenten in Abhängigkeit von den Modelldaten in der Simulationseinheit.

2. Computerimplementiertes Verfahren nach Anspruch 1, wobei das computergestützte Simulationsmodell (SM) mittels einer zweiten maschinellen Lernmethode (NN2) parametrisiert wird, wobei
- aus Modelldaten (MD) eines technischen Systems Parameter für eine Komponente des technischen Systems ermittelt werden,
- und die zweite maschinelle Lernmethode derart trainiert ist, ermittelte Parameter einer Simulationskomponente, die mittels der ersten maschinellen Lernmethode (NN1) einer jeweiligen Komponente zugeordnet ist, zuzuordnen.

3. Computerimplementiertes Verfahren nach einem der vorhergehenden Ansprüche, wobei die erste maschinelle Lernmethode (NN1) und/oder die zweite maschinelle Lernmethode (NN2) eine Methode zur Verarbeitung von Textdaten und/oder ein künstliches neuronales Netz und/oder ein Bayes-Klassifikator umfasst.

4. Computerimplementiertes Verfahren nach einem der vorhergehenden Ansprüche, wobei das technische System und/oder ein Prozess oder eine Funktionalität des technischen Systems mittels des computergestützten Simulationsmodells (SM) computergestützt simuliert wird und Simulationsdaten des computergestützten Simulationsmodells (SM) zum Steuern oder Planen des technischen Systems ausgegeben werden.

5. Computerimplementiertes Verfahren nach Anspruch 4, wobei das technische System und/oder ein Prozess und/oder eine Funktionalität und/oder eine Spezifikation des technischen Systems mittels der computergestützten Simulation und anhand einer vorgegebenen Regel validiert wird.

6. Computerimplementiertes Verfahren nach einem der vorhergehenden Ansprüche, wobei die erste maschinelle Lernmethode (NN1) mittels Trainingsdaten trainiert wurde, anhand von extrahierten zweiten Kennungsdaten aus Modelldaten eines technischen Systems eine Simulationskomponente aus einer Vielzahl von Simulationskomponenten derart zu selektieren und einer Komponente zuzuordnen, dass eine Differenz zwischen den zweiten Kennungsdaten und den ersten Kennungsdaten der Simulationskomponente minimiert wird, wobei die Trainingsdaten eine Vielzahl von Modelldaten von technischen Systemen und erste Kennungsdaten von einer Vielzahl von Simulationskomponenten umfassen.

7. Computerimplementiertes Verfahren nach einem der vorhergehenden Ansprüche, wobei die zweite maschinelle Lernmethode (NN2) mittels der Trainingsdaten derart trainiert wurde, ermittelte Parameter einer Simulationskomponente, die mittels der ersten maschinellen Lernmethode einer jeweiligen Komponente zugeordnet wurde, zuzuordnen.

8. Computerimplementiertes Verfahren nach einem der vorhergehenden Ansprüche, wobei Modelldaten (MD) für ein technisches System Textdaten umfassen, die Produkttypen und/oder der Produktion dieser Produkttypen zugehörige Prozessschritte und/oder eine Reihenfolge von Prozessschritten und/oder vorhandene Komponenten und/oder Positionen vorhandener Komponenten des technischen Systems kennzeichnen.

9. Vorrichtung (100) zum Generieren eines computergestützten Simulationsmodells (SM) für ein technisches System, wobei die Vorrichtung mindestens einen Prozessor zum Durchführen der Schritte eines Verfahrens nach den vorhergehenden Ansprüchen aufweist.

10. Computerprogrammprodukt, das direkt in einen programmierbaren Computer ladbar ist, umfassend Programmcodeteile, die dazu geeignet sind, die Schritte nach einem der Ansprüche 1 bis 8 durchzuführen.
